# EUROPEAN PATENT APPLICATION

(11) **EP 1 788 619 A2**
(43) Date of publication of application: **23.05.2007**
(21) Application number: 06123926.5
(22) Date of filing: 13.11.2006
(51) Int. Cl.: H01L 21/205, H01S 5/323

(54) **Semiconductor device and method of fabricating the same**

(30) Priority: 18.11.2005 KR 20050110882; 19.10.2006 KR 20060102046
(71) Applicant: Samsung Electronics Co., Ltd., Suwon-si Gyeonggi-do (KR)
(72) Inventor: Paek, Ho-sun, c/o Samsung Adv. Inst. of Techn., Yongin-sin, Gyeonggi-do (KR); Lee, Sung-nam, c/o Samsung Adv. Inst. of Techn., Yongin-sin, Gyeonggi-do (KR); Son, Joong-kon, c/o Samsung Adv. Inst. of Techn., Yongin-sin, Gyeonggi-do (KR); Sakong, Tan, c/o Samsung Adv. Inst. of Techn., Yongin-sin, Gyeonggi-do (KR)
(74) Representative: Greene, Simon Kenneth

(57) **Abstract**

Provided are a semiconductor device having an improved surface morphology characteristic, and a method of fabricating the same. The semiconductor device includes: an r-plane sapphire substrate (12); an AlₓGa₍₁₋ₓ₎N(0≤ x<1) buffer layer (14) epitaxially grown on the r-plane sapphire substrate to a thickness in the range of 100-20000 Å in a gas atmosphere containing nitrogen (N₂) and at a temperature of 900-1100°C; and a first a-plane GaN layer (16) formed on the buffer layer.

## Description

### BACKGROUND OF THE INVENTION

The present invention relates to a GaN semiconductor device, and more particularly, to a semiconductor device having an improved surface morphology characteristic, and a method of fabricating the same.

Conventional GaN-based devices, for example, nitride semiconductor laser diodes, are implemented on a c-plane GaN substrate. However, a c-plane of GaN crystal is well-known as a polar plane. Thus, in nitride semiconductor laser diodes, the probability of combining electrons with holes can be reduced by the effect of an internal electric field formed by polarization of the c-plane, which lowers the luminous efficiency of the nitride semiconductor laser diodes.

To solve this problem, a technology of implementing a semiconductor device on an a-plane GaN substrate having no polarization has been developed.

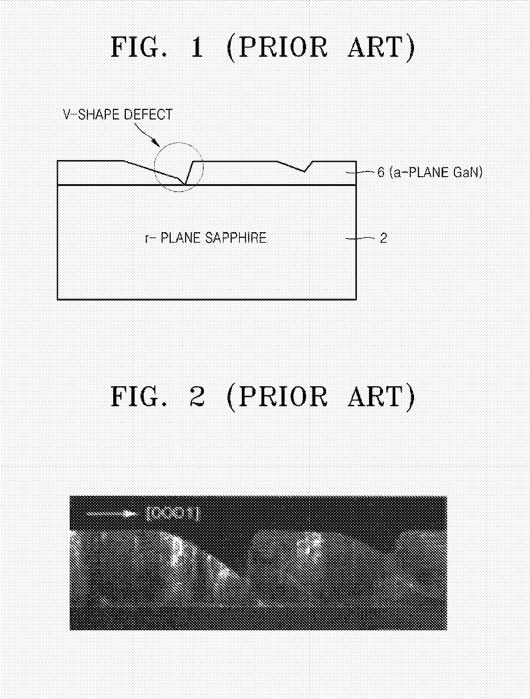

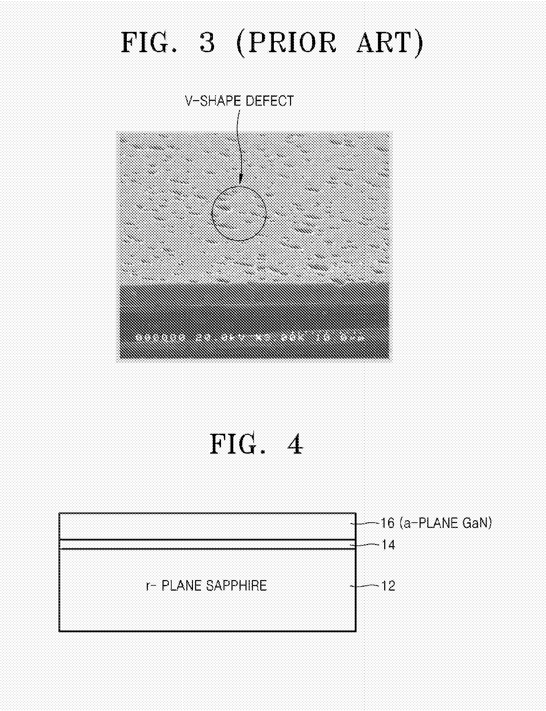

FIG. 1 is a cross-sectional view of a conventional a-plane GaN substrate, and FIGS. 2 and 3 are a cross-section scanning electron microscopy (SEM) photo and a surface SEM photo, respectively, showing the a-plane GaN substrate illustrated in FIG.1.

The a-plane GaN substrate can be obtained by epitaxially growing an a-plane GaN layer 6 on an r-plane sapphire substrate 2. However, lattice mismatch between the r-plane sapphire substrate 2 and the a-plane GaN layer 6 is about 16.2%, considerably large, and thus a V-shape defect caused by stress is generated on the surface of the a-plane GaN layer 6 stacked on the r-plane sapphire substrate 2. Accordingly, when a device is implemented on the surface of the a-plane GaN layer 6 on which the V-shape defect is generated, a device characteristic is lowered.

### SUMMARY OF THE INVENTION

The present invention provides a semiconductor device having an improved surface morphology characteristic, and a method of fabricating the same.

According to an aspect of the present invention, there is provided a semiconductor device comprising: an r-plane sapphire substrate; an AlₓGa₍₁₋ₓ₎N(0≤x<1) buffer layer epitaxially grown on the r-plane sapphire substrate to a thickness in the range of 100-20000 Å in a gas atmosphere containing nitrogen (N₂) and at a temperature of 900-1100°C; and a first a-plane GaN layer formed on the buffer layer.

The gas atmosphere containing N₂ may be a mixed gas atmosphere of N₂ and hydrogen (H₂), and the ratio of N₂ of the mixed gas may be 1-99.99%.

A second a-plane GaN layer may be further grown on the first a-plane GaN layer. Here, the first a-plane GaN layer may be formed of an n-type semicodnuctor including an n-type dopant, and the second a-plane GaN layer may be formed of a p-type semiconductor including a p-type dopant.

According to another aspect of the present invention, there is provided a method of fabricating a semiconductor device comprising: epitaxially growing an AlₓGa₍₁₋ₓ₎N(0≤ x<1) buffer layer on an r-plane sapphire substrate to a thickness in the range of 100-20000 Å in a gas atmosphere containing nitrogen (N₂) and at a temperature of 900-1100°C to form a buffer layer; and forming a first a-plane GaN layer on the buffer layer.

The method may further include forming a second a-plane GaN layer on the first a-plane GaN layer. Here, the first a-plane GaN layer may be formed of an n-type semiconductor including an n-type dopant, and the second a-plane GaN layer may be formed of a p-type semiconductor including a p-type dopant. And, the first a-plane GaN layer and the second a-plane GaN layer may be formed at a temperature of 900-1200°C, and the buffer layer may be formed under a pressure of 1-200 torr.

According to the present invention, a semiconductor device having an improved surface morphology characteristic can be obtained.

### BRIEF DESCRIPTION OF THE DRAWINGS

The above and other features and advantages of the present invention will become more apparent by describing in detail exemplary embodiments thereof with reference to the attached drawings in which:
FIG. 1 is a cross-sectional view of a conventional a-plane GaN semiconductor substrate;
FIG. 2 is a cross-section scanning electron microscopy (SEM) photo of the a-plane GaN semiconductor substrate illustrated in FIG. 1;
FIG. 3 is a surface SEM photo of the a-plane GaN semiconductor substrate illustrated in FIG. 1;
FIG. 4 is a cross-sectional view of a semiconductor device according to an embodiment of the present invention;
FIG. 5 is a cross-section SEM photo of the semiconductor device illustrated in FIG. 4;
FIG. 6 is a surface SEM photo of the semiconductor device illustrated in FIG.4;
FIG. 7 is a cross-sectional view of a semiconductor device according to another embodiment of the present invention;
FIGS. 8 through 8C are flowcharts illustrating a method of fabricating a semiconductor device according to an embodiment of the present invention;
FIG. 9 is a graph of thickness of a buffer layer versus crystallinity of a first a-plane GaN layer in the method of fabricating a semiconductor device illustrated in FIGS. 8A through 8C; and
FIGS. 10A through 10D are flowcharts illustrating a method of fabricating a semiconductor device according to another embodiment of the present invention.

### DETAILED DESCRIPTION OF THE INVENTION

The present invention will now be described more fully with reference to the accompanying drawings, in which exemplary embodiments of the invention are shown. In the drawings, the thicknesses of layers and regions are exaggerated for clarity.

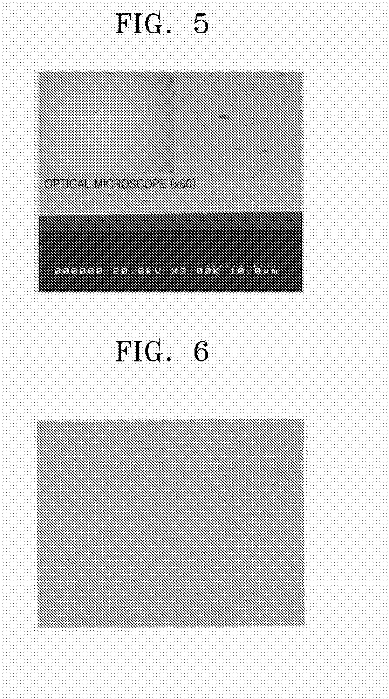

FIG. 4 is a cross-sectional view of a semiconductor device according to an embodiment of the present invention, and FIGS. 5 and 6 are respectively a cross-section SEM photo and a surface SEM photo of the semiconductor device illustrated in FIG. 4.

Referring to FIGS. 4 through 6, the semiconductor device according to an embodiment of the present invention includes an AlₓGa₍₁₋ₓ₎N(0≤ x<1) buffer layer 14 and a first a-plane GaN layer 16, which are sequentially stacked on an r-plane sapphire substrate 12. The semiconductor device illustrated in FIG. 4 may be used as a semiconductor substrate for fabricating a GaN-based device.

The buffer layer 14 may be epitaxially grown to a thickness in the range of 100-20000 Å in a gas atmosphere containing nitrogen (N₂) and at a temperature of 900-1100°C. Here, the gas atmosphere containing N₂ is an N₂ gas atmosphere or a mixed gas atmosphere of N₂ and hydrogen (H₂). When the buffer layer 14 is formed in the mixed gas atmosphere, the ratio of N₂ in the mixed gas may be 1-99.99%. In this case, the buffer layer 14 may be formed under a pressure of 1-200 torr, preferably, under a pressure of 100 torr.

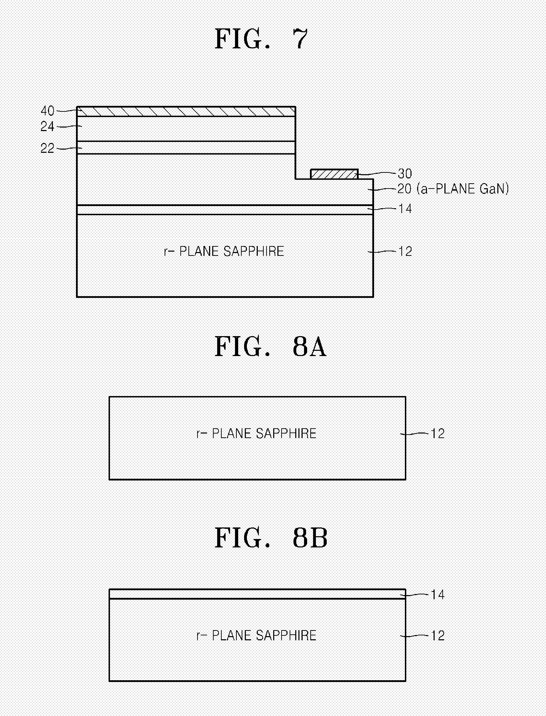

The buffer layer 14 serves to offset lattice mismatch between the r-plane sapphire substrate 12 and the first a-plane GaN layer 16. Thus, a surface morphology characteristic of the a-plane GaN layer 16 that is epitaxially grown on the buffer layer 14 can be improved. Specifically, the first a-plane GaN layer 16 stacked on the buffer layer 14 does not include a V-shape defect and may have a mirror-like surface morphology. In particular, since an a-plane of GaN crystal is well-known as a non-polar plane, when a GaN-based device, for example, a nitride semiconductor laser diode, is implemented on the semiconductor device (see FIG. 7), the luminous efficiency and optical power of the nitride semiconductor laser diode can be improved.

FIG. 7 is a cross-sectional view of a semiconductor device according to another embodiment of the present invention. As illustrated in FIG. 7, the semiconductor device may be implemented as a nitride semiconductor laser diode.

Referring to FIG. 7, the semiconductor device, that is, the nitride semiconductor laser diode, includes an AlₓGa₍₁₋ₓ₎N(0≤ x<1) buffer layer 14, a first a-plane GaN layer 20, an active layer 22, and a second a-plane GaN layer 24, which are sequentially stacked on an r-plane sapphire substrate 12. And, an n-electrode 30 and a p-electrode 40 are formed using a conductive material, such as Ag or Au, on a step portion of the first a-plane GaN layer 20 and the second a-plane GaN layer 24.

The buffer layer 14 may be epitaxially grown to a thickness in the range of 100-20000 Å in a gas atmosphere containing nitrogen (N₂) and at a temperature of 900-1100°C. Here, the gas atmosphere containing N₂ is an N₂ gas atmosphere or a mixed gas atmosphere of N₂ and hydrogen (H₂). When the buffer layer 14 is formed in the mixed gas atmosphere, the ratio of N₂ in the mixed gas may be 1-99.99%. In this case, the buffer layer 14 may be formed under a pressure of 1-200 torr, preferably, under a pressure of 100 torr. The buffer layer 14 formed in such a process may serve to offset lattice mismatch between the r-plane sapphire substrate 12 and the first a-plane GaN layer 20. Thus, a surface morphology characteristic of the first a-plane GaN layer 20 that is epitaxially grown on the buffer layer 14 can be improved. Specifically, the first a-plane GaN layer 20 stacked on the buffer layer 14 does not include a V-shape defect and may have a mirror-like surface morphology.

In the semiconductor device illustrated in FIG. 7, the first a-plane GaN layer 20 may be formed of an n-type semiconductor including an n-type dopant, and the second a-plane GaN layer 24 may be formed of a p-type semiconductor including a p-type dopant. Specifically, the first a-plane GaN layer 20 is an n-GaN-based III-V-group nitride-based compound semiconductor layer and in particular, may be an n-GaN layer. However, the first a-plane GaN layer 20 is not limited to this and may be another compound semiconductor layer of III-V-group in which laser oscillation (lasing) can be performed. In addition, the second a-plane GaN layer 24 is a p-GaN-based III-V-group nitride-based compound semiconductor layer and in particular, may be a p-GaN layer. However, the second a-plane GaN layer 24 is not limited to this and may be another compound semiconductor layer of III-V-group in which laser oscillation (lasing) can be performed.

A material layer in which lasing can be performed can be used as the active layer 22. A material layer in which laser light having small threshold current and stable latitudinal mode characteristic can be oscillated may be used as the active layer 22. A GaN-based III-V group nitride-based compound semiconductor layer, InₓAl_{y}Ga_{1-x-y}N (0≤*x*≤1, 0≤*y*≤1 *and x* + *y <* 1), in which Al is contained at a predetermined ratio may be used as the active layer 22. The active layer 22 may have one of a multiple quantum well structure and a single quantum well structure, and the structure of the active layer 22 does not restrict the technical scope of the present invention.

As described above, the semiconductor device illustrated in FIG. 7 has an excellent surface morphology characteristic and has the upper plane formed of a non-polar plane. Thus, the surface characteristics of thin films stacked on the first a-plane GaN layer 20, that is, the active layer 22 and the second a-plane GaN layer 24 can be improved. As such, the internal quantum efficiency and optical extraction efficiency of the nitride semiconductor laser diode can be improved, thereby improving the luminous efficiency and optical power.

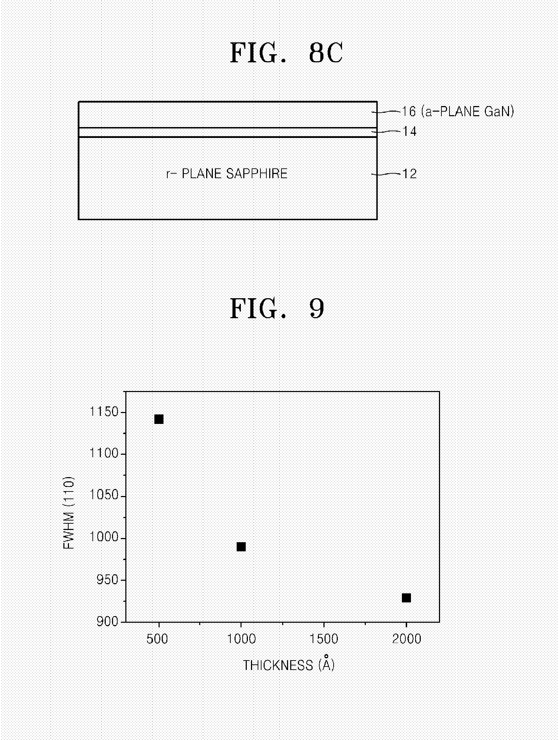

FIGS. 8A through 8C are flowcharts illustrating a method of fabricating a semiconductor device according to an embodiment of the present invention. Each layer may be formed using chemical vapor deposition (CVD). CVD includes atomic layer deposition (ALD), metal organic CVD (MOCVD), and other well-known vapor deposition.

Referring to FIGS. 8A through 8C, an r-plane sapphire substrate 12 is prepared and then, AlₓGa₍₁₋ₓ₎N (0≤*x*<1) is epitaxially grown on the r-plane sapphire substrate 12 to a thickness in the range of 100-20000 Å in a gas atmosphere containing nitrogen (N₂) and at a temperature of 900-1100°C, thereby forming a buffer layer 14. Here, the gas atmosphere containing N₂ is an N₂ gas atmosphere or a mixed gas atmosphere of N₂ and hydrogen (H₂). When the buffer layer 14 is formed in the mixed gas atmosphere, the ratio of N₂ in the mixed gas may be 1-99.99%. In this case, the buffer layer 14 may be formed under a pressure of 1-200 torr, preferably, under a pressure of 100 torr.

After the buffer layer 14 is grown, a first a-plane GaN layer 16 is formed on the buffer layer 14. The first a-plane GaN layer 16 may be formed at a temperature of 900-1200°C. The first a-plane GaN layer 16 may be formed of an n-type semiconductor including an n-type dopant.

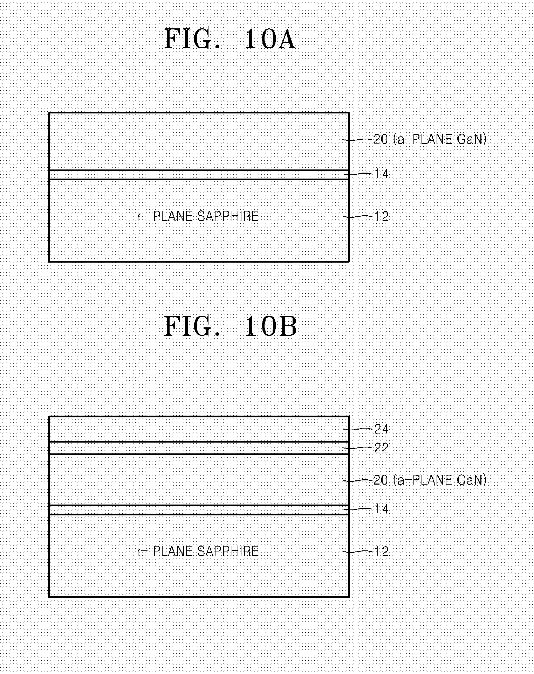

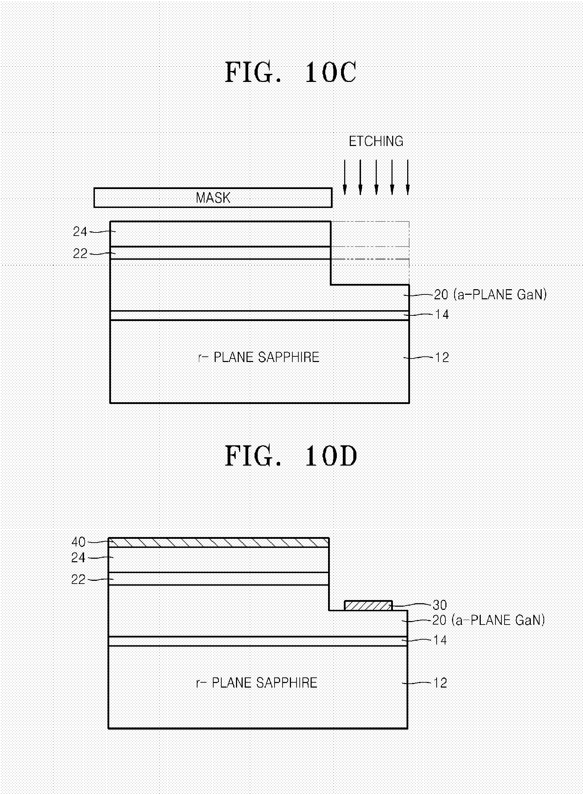

The buffer layer 14 may be interposed between the r-plane sapphire substrate 12 and the first a-plane GaN layer 16 and may serve to offset lattice mismatch between the r-plane sapphire substrate 12 and the first a-plane GaN layer 16. As such, a surface morphology characteristic of the first a-plane GaN layer 16 that is stacked on the the buffer layer 14 is improved, does not include a V-shape defect and may have a mirror-like surface morphology. In particular, since an a-plane of GaN crystal is well-known as a non-polar plane, when a GaN-based device, for example, a nitride semiconductor laser diode, is implemented on the semiconductor (see FIG. 10), the luminous efficiency and optical power of the nitride semiconductor laser diode can be improved. In particular, in the fabrication process according to the present invention, when the buffer layer 14 is epitaxially grown, the thickness of the buffer layer 14 is controlled such that crystallinity of the first a-plane GaN layer 16 stacked thereon is controlled. This will be described with reference to FIG. 9.

FIG. 9 is a graph of thickness of a buffer layer versus crystallinity of a first a-plane GaN layer in the method of fabricating a semiconductor device illustrated in FIGS. 8A through 8C. Referring to FIG. 9, crystallinity of the first a-plane GaN layer 16 depends on the thickness of the buffer layer 14. Specifically, as the thickness of the buffer layer 14 increases, the crystallinity of the first a-plane GaN layer 16 is improved.

FIGS. 10A through 10D are flowcharts illustrating a method of fabricating a semiconductor device according to another embodiment of the present invention. A nitride semiconductor laser diode is implemented as a semiconductor device, as illustrated in FIGS. 10A through 10D. Here, the method of fabricating a semiconductor device illustrated in FIGS. 10A through 10D may include the same processes as those of the method fabricating a semiconductor device illustrated in FIGS. 8A through 8C. Thus, for repeated and the same processes, FIGS. 8A through 8C and a description thereof will be referred to.

Referring to FIGS. 10A and 10B, an r-plane sapphire substrate 12 is prepared and then, AlₓGa₍₁₋ₓ₎N (0≤*x*≤1) is epitaxially grown on the r-plane sapphire substrate 12 to a thickness in the range of 100-20000 Å in a gas atmosphere containing nitrogen (N₂) and at a temperature of 900-1100°C, thereby forming a buffer layer 14. After that, a first a-plane GaN layer 20, an active layer 22, and a second a-plane GaN layer 24 are sequentially formed on the buffer layer 14.

In particular, in the fabrication process according to the present invention, when the buffer layer 14 is epitaxially grown, the thickness of the buffer layer 14 is controlled such that crystallinity of the first a-plane GaN layer 16 stacked thereon is controlled, as described previously.

The first a-plane GaN layer 20 may be formed of an n-type semiconductor including an n-type dopant, and the second a-plane GaN layer 24 may be formed of a p-type semiconductor including a p-type dopant. Each of the first a-plane GaN layer 16 and the second a-plane GaN layer 24 may be formed at a temperature of 900-1200°C.

Specifically, the first a-plane GaN layer 20 may be an n-GaN-based III-V-group nitride-based compound semiconductor layer, and in particular, may be an n-GaN layer. However, the first a-plane GaN layer 20 is not limited to this and may be another compound semiconductor layer of III-V group in which laser oscillation (lasing) can be performed. In addition, the second a-plane GaN layer 24 may be a p-GaN-based III-V-group nitride-based compound semiconductor layer, and in particular, may be a p-GaN layer. However, the second a-plane GaN layer 24 is not limited to this and may be another compound semiconductor layer of III-V group in which laser oscillation (lasing) can be performed.

A material layer in which lasing can be performed can be used as the active layer 22. A material layer in which laser light of which threshold current value is small and latitudinal mode characteristic is stable can be oscillated may be used as the active layer 22. A GaN-based III-V group nitride-based compound semiconductor layer, InₓAl_{y}Ga_{1-x-y}N (0≤ *x*≤ 1, 0≤ *y≤* 1 *and x* + *y* < 1), in which Al is contained at a predetermined ratio may be used as the active layer 22. The active layer 22 may have one of a multiple quantum well structure and a single quantum well structure, and the structure of the active layer 22 does not restrict the technical scope of the present invention.

Referring to FIGS. 10C and 10D, a predetermined region is selected on the second a-plane GaN layer 24 which is the uppermost layer, and is etched/removed to a predetermined depth of the first a-plane GaN layer 20, thereby forming a step portion on the first a-plane GaN layer 20. After that, the n-electrode 30 and the p-electrode 40 are formed using a conductive material, such as Ag or Au, on the step portion of the first a-plane GaN layer 20 and the second a-plane GaN layer 24.

In the semiconductor device illustrated in FIG. 7, since the first a-plane GaN layer 20 has an excellent surface morphology characteristic and has the uppermost plane formed of a non-polar plane, the surface characteristics of thin films stacked on the first a-plane GaN layer 20, that is, the active layer 22 and the second a-plane GaN layer 24, can be improved. As such, the internal quantum efficiency and optical extraction efficiency of the nitride semiconductor laser diode can be improved, thereby improving the luminous efficiency and optical power.

According to the present invention, the nitride-based semiconductor device having an improved surface morphology characteristic can be obtained. The semiconductor device according to the present invention does not include the V-shape defect and has a mirror-like surface morphology. In particular, since the a-plane of GaN crystal is well-known as a non-polar plane, when the GaN-based device, for example, a nitride semiconductor laser diode, is implemented on the first a-plane GaN layer 20 formed on the buffer layer 14 in the semiconductor device according to the present invention, luminous efficiency and optical power of the nitride semiconductor laser diode can be improved.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A semiconductor device comprising:
an r-plane sapphire substrate;
an AlₓGa₍₁₋ₓ₎N(0≤ x<1) buffer layer epitaxially grown on the r-plane sapphire substrate to a thickness in the range of 100-20000 Å in a gas atmosphere containing nitrogen (N₂) and at a temperature of 900-1100°C; and
a first a-plane GaN layer formed on the buffer layer.

2. The semiconductor device of claim 1 or 2, wherein the first a-plane GaN layer has a mirror-like surface morphology.

3. The semiconductor device of claim 1, wherein the gas atmosphere containing N₂ is a mixed gas atmosphere of N₂ and hydrogen (H₂).

4. The semiconductor device of claim 3, wherein the ratio of N₂ of the mixed gas is 1-99.99%.

5. The semiconductor device of any preceding claim, wherein a second a-plane GaN layer is further grown on the first a-plane GaN layer.

6. The semiconductor device of claim 5, wherein the second a-plane GaN layer includes a p-type dopant.

7. The semiconductor device of claim 6, wherein the second a-plane GaN layer is formed of a p-type semiconductor.

8. The semiconductor device of claim 5, 6 or 7, wherein the second a-plane GaN layer is grown at a temperature of 900-1200°C.

9. The semiconductor device of any preceding claim, wherein the first a-plane GaN layer includes an n-type dopant.

10. The semiconductor device of claim 9, wherein the first a-plane GaN layer is formed of an n-type semiconductor.

11. The semiconductor device of any preceding claim, wherein the first a-plane GaN layer is grown at a temperature of 900-1200°C.

12. The semiconductor device of any preceding claim, wherein the buffer layer is formed under a pressure of 1-200 torr.

13. A semiconductor device comprising:
an r-plane sapphire substrate;
an AlₓGa(₁₋ₓ)N(0≤ x<1) buffer layer epitaxially grown on the r-plane sapphire substrate to a thickness in the range of 100-20000 Å in a gas atmosphere containing nitrogen (N₂) and at a temperature of 900-1100°C;
a first a-plane GaN layer formed on the buffer layer and including an n-type dopant;
an active layer formed on the first a-plane GaN layer; and
a second a-plane GaN layer formed on the active layer and including a p-type dopant.

14. A method of fabricating a semiconductor device comprising:
epitaxially growing an AlₓGa₍₁₋ₓ₎N(0≤ x<1) buffer layer on an r-plane sapphire substrate to a thickness in the range of 100-20000 Å in a gas atmosphere containing nitrogen (N₂) and at a temperature of 900-1100°C to form a buffer layer; and
forming a first a-plane GaN layer on the buffer layer.

15. The method of claim 14, wherein the first a-plane GaN layer has a mirror-like surface morphology.

16. The method of claim 14 or 15, wherein the gas atmosphere containing N₂ is a mixed gas atmosphere of N₂ and hydrogen (H₂).

17. The method of claim 16, wherein the ratio of N₂ of the mixed gas is 1-99.99%.

18. The method of any of claims 14 to 17, further comprising forming a second a-plane GaN layer on the first a-plane GaN layer.

19. The method of claim 18, wherein the second a-plane GaN layer is formed to include a p-type dopant.

20. The method of claim 19, wherein the second a-plane GaN layer is formed of a p-type semiconductor.

21. The method of claim 18, 19 or 20, wherein the second a-plane GaN layer is formed at a temperature of 900-1200°C.

22. The method of any of claims 14 to 21, wherein the first a-plane GaN layer is formed to include an n-type dopant.

23. The method of claim 22, wherein the first a-plane GaN layer is formed of an n-type semiconductor.

24. The method of claim 14, wherein the first a-plane GaN layer is formed at a temperature of 900-1200°C.

25. The method of any of claims 14 to 24, wherein the buffer layer is formed under a pressure of 1-200 torr.

26. The method of any of claims 14 to 25, wherein crystallinity of the first a-plane GaN layer is controlled by controlling a thickness of the buffer layer.

27. A method of fabricating a semiconductor device comprising:
epitaxially growing an AlₓGa₍₁₋ₓ₎N(0≤ x<1) buffer layer on an r-plane sapphire substrate to a thickness in the range of 100-20000 Å in a gas atmosphere containing nitrogen (N₂) and at a temperature of 900-1100°C to form a buffer layer;
forming a first a-plane GaN layer including an n-type dopant on the buffer layer;
forming an active layer on the first a-plane GaN layer; and
forming a second a-plane GaN layer including a p-type dopant on the active layer.
